# EUROPEAN PATENT SPECIFICATION

(11) **EP 0 380 964 B1**
(45) Date of publication and mention of the grant of the patent: **21.05.1997**
(21) Application number: 90100909.2
(22) Date of filing: 17.01.1990
(51) Int. Cl.: H01L 21/82

(54) **Method of making a semiconductor device having a contact member**
Verfahren zur Herstellung eines Halbleiterbauelements mit einem Kontaktteil
Procédé de fabrication d'un dispositif à semi-conducteur comprenant un membre de contact

(30) Priority: 31.01.1989 JP 21807/89
(43) Date of publication of application: 08.08.1990
(73) Proprietor: TEXAS INSTRUMENTS INCORPORATED, Dallas Texas 75265 (US)
(72) Inventor: Cho, Songsu, Kitasoma-Gun, Ibaraki-Ken (JP); Hasegawa, Shinichi, Tsuchiura-City, Ibaraki-Ken (JP)
(74) Representative: Leiser, Gottfried, Dipl.-Ing.

(56) References cited:
- EP-A- 0 127 020
- EP-A- 0 272 051
- "VLSI Technology", S.M.Sze, 1983, pages 169-171

## Description

### DETAILED DESCRIPTION OF THE INVENTION

### FIELD OF USE IN INDUSTRY

This invention relates to a fabrication method of semiconductor devices, for example, to static RAMs (Random Access Memories).

### PRIOR ART

Conventionally static RAMs, for example, have severe restrictions on pattern layouts, because many wirings such as ground wires and bit lines have to be passed through regions of small area. Thus, in silicon gate MOS integrated circuits, a so called "direct contact" method is generally known, in which gate electrodes are not connected to diffusion layers (sources, drains, or regions corresponding thereto) by conventional metal wiring layers such as Al or the like but are connected directly to the diffusion layers using polysilicon or the like. By using the direct contact method, pattern layouts in said static RAMs or the like is defined more freely, and the degree of integration increases, because metal wiring layers such as, for example, power source supply wires, can be disposed directly over connecting parts or the like of the gate electrodes and the diffusion layers.

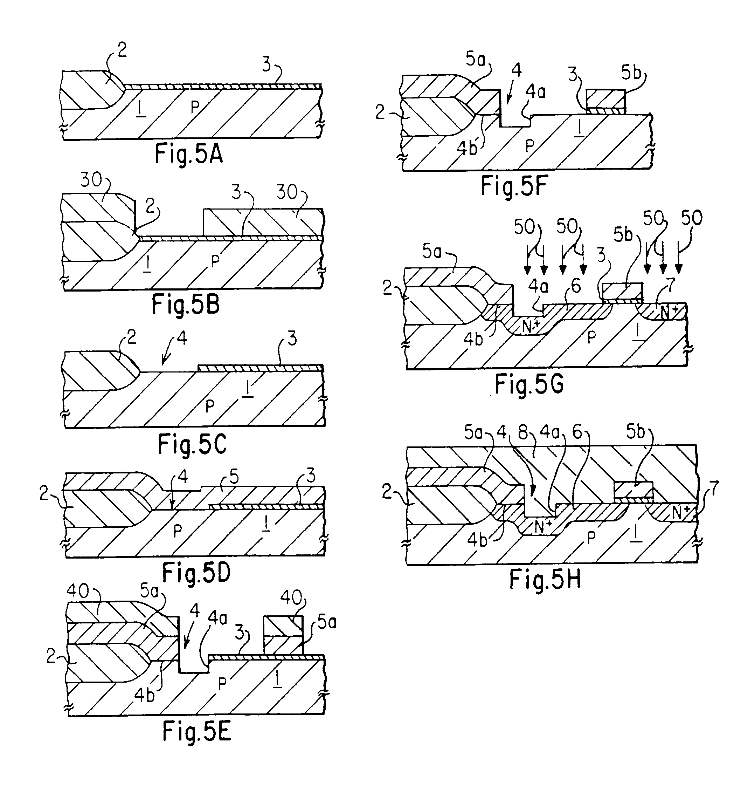

However, semiconductor devices fabricated by said direct contact method have several serious problems which cannot be avoided in their processes. Hereinbelow, an example of a fabrication process of semiconductor devices by the direct contact method and its problems will be discussed in regard to Figures 5A to 5H. To facilitate the understanding, the figures are partly exaggerated.

First, as shown in Figure 5A, a field oxide film 2 for element separation is grown on a P type silicon substrate 1 by a well-known LOCOS (Local Oxidation of Silicon) method, and then a gate oxide film 3 is formed by thermal oxidation.

Next, after a predetermined area is covered by, for example, a photoresist 30, as shown in Figure 5B, the gate oxide film 3 in a predetermined area is etched away as shown in Figure 5C (this forms a predetermined contact part 4).

Next, as shown in Figure 5D, a polysilicon layer 5 is deposited on the entire face including the contact part 4 by a well-known CVD (Chemical Vapor Deposition) method; and the polysilicon layer 5 is doped by, for example, phosphorus or the like to be N type; and then after a predetermined area is covered by a photoresist 40, a pattern is defined by, for example, a dry etching in order to leave only a predetermined polysilicon layer 5a (wiring layer) and 5b (gate electrode) as shown in Figure 5E. At this time, the P type silicon substrate 1 is also etched by patterning to form a recessed part 4a as shown in the figure. The recessed part 4a in the figure is exaggerated to facilitate the understanding as said in the above. Also, 4b in the figure is a connecting region of the polysilicon layer 5a and the P type silicon substrate 1 (that is, an N⁺ type diffusion region which will be described later).

Next, as shown in Figure 5F, the gate oxide film 3 in a predetermined region is etched away except directly below the polysilicon layer 5b, using the above photoresist 40.

Next, a predetermined area is selectively ion implanted with an N type impurity (for example As) 50 and is annealed (thermal treatment) to form N⁺ type diffusion region 6 and 7 (source region and drain region) as shown in Figure 5G; and furthermore, an interlevel insulating layer 8 (a phosphorus glass film such as, for example, PSG (Phosphosilicate Glass) or BPSG (Borophosphosilicate Glass)) is deposited as shown in Figure 5H.

Below are the problems which are found after variously examining devices obtained by the fabrication process described in the above.
(1) As shown Figures 5G and 5H, in addition to the above recessed part 4a, the above connecting area 4b in the contact part 4 requires a predetermined region (area) in order to secure connection characteristic of the polysilicon layer (wiring layer) 5a and the N⁺ type diffusion region (source region) 6. Therefore, device size reduction has naturally a limit, which is disadvantageous to high degree of integration.
(2) With regard to the above Figure 5B, when the gate oxide film 3 in the predetermined region (the contact part 4 in Figure 5C) is removed, the other region (where a gate electrode 5b will be formed later) covered with the photoresist 30 as shown in the figure; and because this photoresist 30 is an organic substance, it also contaminates the gate oxide film 3 in the region which should form the gate electrode 5b (this will significantly lower the reliability of devices). Therefore, the gate oxide film 3 needs to be cleaned in the state shown in Figure 5C by using various cleaning methods, which will also be very disadvantageous in the process.
(3) Furthermore, with regard to the above Figure 5C, in the contact part 4 with the gate oxide film 3 in the predetermined area being etched away, a natural oxide film is formed because the below lying P type silicon substrate 1 is exposed. In order to stabilize the connecting characteristic of the P type silicon substrate 1 and the polysilicon layer 5 deposited later in Figure 5D, the above natural oxide film has to be removed by a wet etching or the like with a water solution of, for example, HF (hydrogen fluoride) or the like, just before the polysilicon layer 5 is deposited (this will be, of course, disadvantageous in the process like the above (1)). However, when the nature oxide layer is etched away, the gate oxide film 3 is also etched; and the thickness of the gate oxide film 3 on which the gate electrode 5b should be formed becomes uneven, so that the reliability of the devices is significantly lowered.
(4) As described in the above, in a mask process of the photoresist 40 or the like in Figure 5E, the contact part 4 has to have a given excess region (area), when considering a contact part 4 wider than the contact area of the polysilicon layer 5a, or an alignment difference, or the like. For example, if the P type silicon substrate 1 is exposed by the above alignment difference or the like, a dry etching or the like etches also the underlying P type silicon substrate 1 (the recessed part 4a), which significantly lowers the reliability of the devices.

From EP-A-0 272 051 a method is known which includes the steps of the precharacterizing part of claim 1. However, no self-diffusion step is used in this method for creating or augmenting an electrical connection between a contact member and a dopant region.

### PURPOSE OF THE INVENTION

A purpose of the invention is to provide semiconductor devices which are highly reliable and permit high degree of integration, and a fabrication method thereof.

### STRUCTURE OF THE INVENTION

To this effect the method defined in the precharacterizing part of claim 1 is completed by the method steps contained in the characterizing part thereof.

### BRIEF DESCRIPTION OF THE DRAWINGS

Figures 1 - 4 show embodiments of the invention;
Figure 1 is a cross sectional view of a main part of a static RAM;
Figure 2 is an equivalent circuit diagram of Figure 1;
Figures 3A - 3I are cross sectional views sequentially showing the main steps of the fabrication method of the device in Figure 1; and
Figure 4 is a cross sectional view of a device of another embodiment.
Figures 5A - 5H are cross sectional views sequentially showing the main steps of the fabrication method of a device by a prior direct contact method.

In reference numerals shown in the figures:
1...semiconductor substrate;
2...field oxide film;
3...gate oxide film;
5a...wiring layer;
5b...gate electrode;
6...source region (N⁺ type diffusion region);
7...drain region (N⁺ type diffusion region);
8...interlevel insulating film;
9...contact hole;
10...diffusion region;
11...polysilicon layer (conductive layer); and
12...adjacent region.

### EMBODIMENTS

Hereinafter, embodiments of the invention will be described.

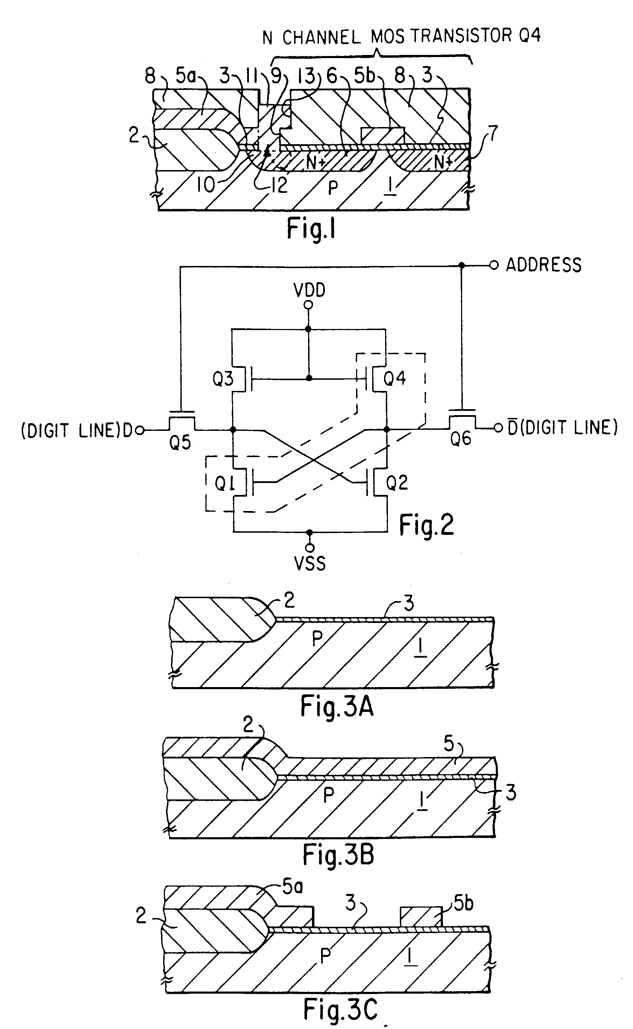

Figures 1 - 3 show an embodiment in which the invention is applied to a static RAM.

As shown in Figure 1, and N⁺ type source region 6 and an N⁺ type drain region 7 are formed in a predetermined pattern in a major surface of a P type silicon substrate 1; a gate electrode 5b is provided therebetween through a gate oxide film 3; and an N channel MOS transistor (for example, a transistor Q₄ in Figure 2) is structured.

Also, a wiring layer 5a of a predetermined pattern (for example, this wiring layer 5a is connected to a gate of an N channel MOS transistor Q₁ in Figure 2) is formed on the gate oxide film 3 and a field oxide film 2 formed on the P type silicon substrate 1; an N⁺ type diffusion region 10 is formed by self-diffusion under a contact hole 9 formed in an adjacent region 12 of the wiring layer 5a; and this N⁺ type diffusion region 10 is connected to the source region 6. A polysilicon layer 11 (conductive layer) is deposited into the contact hole 9, in a state of connection to the wiring layer 5a. 13 in the figure is a groove. Figure 2 is an equivalent circuit diagram showing an example of the static MOS memory. Q₁ - Q₆ in Figure 2 are N channel MOS transistors respectively.

As described in the above, a device of the invention includes the wiring layer 5a of the predetermined pattern formed through the gate oxide film 3, the N⁺ type diffusion layer formed under the contact hole 9 formed in the gate oxide film 3 in the adjacent region 12 of the wiring layer 5a, and the polysilicon layer 11 deposited into the contact hole 9 in a state of connection to the wiring layer 5a, so that the area of a region (the gate oxide film 3 under the wiring layer 5a and the adjacent region 12 of the wiring layer 5a in Figure 1), which corresponds to the contact part 4 (the connecting region 4b and a region of the recess part 4a) in a device by the conventional direct contact method as shown in Figure 5, can be reduced. That is, because the wiring layer 5a is connected to the polysilicon layer 11 (which is connected to the diffusion region 10) in Figure 1, the connection characteristic may be sufficiently secured in this part. Therefore, the gate oxide film 3 under the wiring layer 5a may be smaller (however, this gate oxide film 3 may not entirely removed), so that the area of the above wiring layer 5a and the gate oxide film 3 may be reduced. Also, because the connection to the N⁺ type diffusion region (source region) 6 is made by the self-diffusion of the polysilicon layer 11 buried in the contact hole 9 (that is, by the N⁺ type diffusion region 10), there is little need to consider an excess area by, for example, alignment difference or the like, which is very advantageous to reduction of the device size. Thus, the defects in the direct contact method may be solved, and the high degree of integration of the device is made possible, taking advantage of its characteristic.

Next, with regard to Figures 3A to 3I, a fabrication method of the device of the embodiment will be described.

First, as shown in Figure 3A, a field oxide film 2 (for example, 8000Å thick) is grown on a P type silicon substrate 1 by a well-known LOCOS method, and then a gate oxide film 3 (for example, 200Å thick) is formed on the silicon substrate 1 by thermal oxidation.

Next, a polysilicon layer 5 (for example 5000Å thick) is deposited over the entire face by a well-known, for example, low pressure CVD method; then phosphorus, for example, is deposited by a CVD method at 950 degrees centigrade; and a thermal treatment is performed to dope the polysilicon layer 5 to be an N type. Furthermore, as shown in Figure 3C, after a predetermined area is covered by a mask (for example, photoresist, not shown), a predetermined pattern is defined by, for example, dry etching to form a wiring layer 5a and a gate electrode 5b.

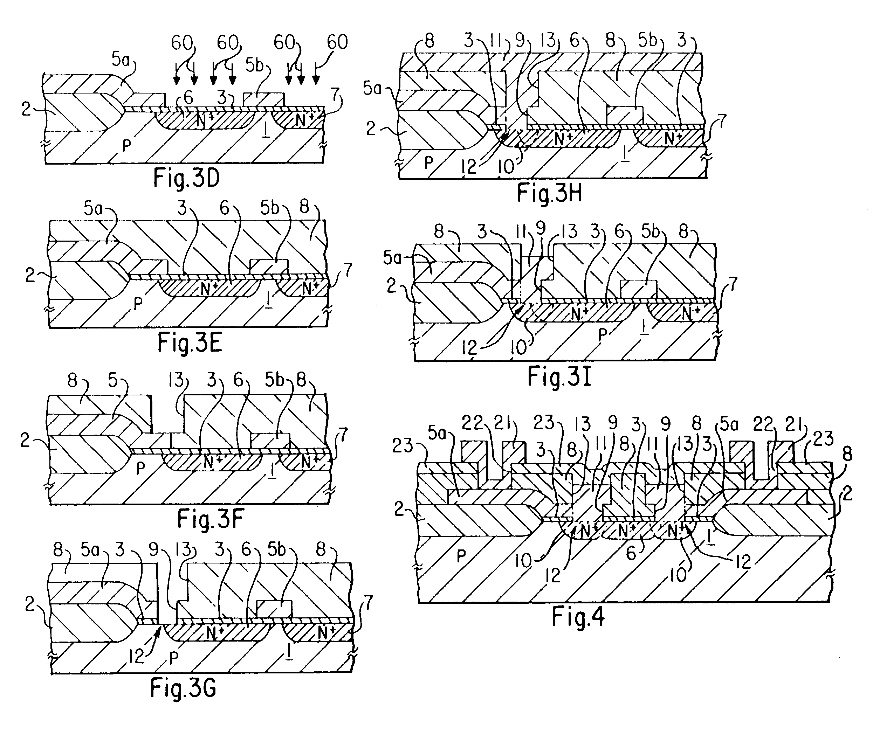

Next, as shown in Figure 3D, ion 60 of an N type impurity (for example As) is selectively implanted by a well-known ion implantation method, and an annealing is performed at 950 degrees centigrade to form the N⁺ type diffusion region 6 and 7 (source region and drain region). Then, as shown in Figure 3E, an interlevel insulating layer 8 (for example, BPSG or the like) is deposited over the entire face by, for example, a normal pressure CVD method, and a steam treatment is performed at 850 degrees centigrade to planarize the interlevel insulating layer 8 and to increase the degree of oxidation (insulation).

Next, as shown in Figure 3F, a predetermined area is covered with a mask (for example, photoresist, not shown); then a groove 13 is formed by, for example, a dry etching of the interlevel insulating layer 8 in a predetermined area; and a contact hole 9 is formed by etching away the polysilicon layer 5a and removing the gate oxide film 3 by a predetermined dry etching as shown in Figure 3G.

Next, as shown in Figure 3H, a polysilicon layer 11 is deposited by a well-known decreased pressure CVD method over the entire face which includes the contact hole 9 and the groove 13, and the polysilicon layer 11 is made low resistance by annealing at 900 degrees centigrade. At the same time, an N⁺ type diffusion region 10 is formed by self-diffusion under the contact hole 9 to be connected to the source region 6. This connects the polysilicon layer 11 and the wiring layer 5a. As described in the above, one process may be omitted by performing the deposition of the polysilicon layer 11 and the anneal at the same step, which is advantageous.

Next, as shown in Figure 3I, a predetermined etching is performed, and the polysilicon layer 11 is left only within the contact hole 9 and the groove 13.

Although the latter processes are not shown, to avoid for example, a short between the polysilicon layer 11 and a metal wiring layer, a layer of SiO₂ (for example, 3000Å thick) is again deposited by, for example, a well-known decreased pressure CVD method, and each normal wiring treatment is performed to complete the device.

As is seen from the above description of the fabrication process, because the device of the embodiment and the fabrication method thereof do not require a mask process which removes the gate oxide film 3 in the predetermined region as in the conventional direct contact method shown in Figure 5B, the reliability of the device may be secured without contamination of the gate oxide film 3. Also, because a cleaning process for the contaminated gate oxide film 3 is not required as in conventional processes, it is an advantageous process without increased number of steps.

Also, because a process to expose the P⁺ type silicon substrate 1 as is shown in Figure 5C does not exist, a natural oxide film would not be formed. Therefore, adverse effects on the gate oxide film 3 by wet etching or the like (the gate oxide film 3 is also etched by this etching to have uneven film thickness) is not of concern, and the reliability of the devices can be increased.

Also, the P type silicon substrate 1 would not be exposed by alignment difference of the mask or the like as in the patterning of the polysilicon layer 5 shown in Figure 5E (because of the gate oxide film 3 as shown in Figure 3C), the P type silicon substrate 1 would not be also etched by a dry etching or the like (because the gate oxide film 3 works as a mask in patterning the polysilicon layer 5). Therefore, it is advantageous for the reliability of the device.

Figure 4 shows another embodiment of the invention, for instance, an embodiment structured as a diffusion resistance element. The same reference numbers are used for the places corresponding to Figure 1.

As shown in Figure 4, the embodiment is basically structured quite similar to the one in Figure 1, but the difference is that it is structured to have, for example, an N⁺ type diffusion region 10 connected to an N⁺ type diffusion region 6 (the source region in the embodiment in Figure 1) in the region where the gate electrode 5b and the drain region 7 are formed in Figure 1 (the region in the right side of Figure 1). That is, the gate electrode as in the above embodiment of Figure 1 does not exist; the above structure is provided symmetrically with the N⁺ type diffusion region 6 in-between; the two diffusion regions 10 are each connected to the N⁺ type diffusion region 6; and the diffusion resistance is formed there.

21 in the figure are electrodes to take out the wiring layer 5a; 22 are through holes; and 23 is a SiO₂ layer.

Since the device of the embodiment has the similar structure as in the above embodiment of Figure 1, it has the same advantage as in the above embodiment, and it is also structurally convenient for electrical testing.

That is, a direct contact structure of the invention may be easily checked by using the two diffusion regions 10 and the diffusion region 6 connected thereto shown in the figure as a diffusion resistance and measuring the electric characteristics thereof.

Resistive valve of 30 - 50 ohm per 1 contact hole may be actually freely controlled, and also very good contact characteristic may be obtained.

Next, a fabrication method of the device of the embodiment is briefly described regarding Figure 3; in processing from the state in Figure 3B to the state in Figure 3C, instead of forming the gate electrode 5b, the wiring layer 5a of the predetermined pattern is formed also in the opposing region (in Figure 3, the field oxide film 2 or the like in the opposing region is omitted). Then as in Figure 3D, the N⁺ type diffusion region 6 (7) is selectively formed in a predetermined region by an ion implantation and a thermal treatment; in Figure 3E and on, an insulating layer 23 is formed after each similar process; and then each wiring treatment completes the device in Figure 4.

Although the invention has been illustrated hereinabove, the above embodiments may be modified based on the technical idea of the invention.

For example, although polysilicon is used for the conductive layer 11 deposited into the contact hole 9 in the above embodiments, other metal such as Al or the like may be deposited (in this case, metal or the like is deposited after the diffusion layer 10 is previously formed by an impurity diffusion by a conventional art). Also in the above embodiments, the deposition of the conductive layer (polysilicon layer) 11 and the formation of the diffusion layer 10 by annealing may be performed at the same time. Or, the conductive layer 11 may be deposited after the formation of the diffusion layer 10. Or, the diffusion may be performed by an adequate optical excitation treatment such as laser anneal, lamp anneal, or the like.

Although the invention is applied to, for example, the N channel MOS transistor Q₄ and Q₁ within broken lines in Figure 2 in the above embodiments (that is, it is used for connecting the source of the transistor Q₄ and the gate of the transistor Q1), it may also be applied for connecting the drain of the transistor Q₅ and the gate of the transistor Q₂, and connecting the source of the transistor Q₄ and the drain of the transistor Q₂, and so on, in the same figure.

Also, the invention may be applied to appropriate places in other devices.

The conductivity types of the each above semiconductor region may be reversed, and the invention may be applied to the appropriate other than static RAMs, for example dynamic RAMs or the like.

### EFFECTS OF THE INVENTION

As described above, because the invention comprises: a wiring layer with a predetermined pattern formed over a major surface of a semiconductor substrate through an insulating film, a diffusion layer formed under a contact hole formed in said insulation film in an adjacent region of the wiring layer, and a conductive layer deposited into said contact hole in a state of being connected to said wiring layer, are occupied by said insulating film and wiring layer and also area of the adjacent region of said wiring layer may be reduced, which allows high degree of integration.

Also, because the contact hole is formed after patterning of the wiring layer over said insulating film, a process of etching said insulating film may be performed without contamination or the like of said insulating film.

Also, because a semiconductor substrate is protected by said insulating film, no exposure or the like of the semiconductor substrate occurs, nor does etching or the like of said semiconductor substrate in patterning or the like of said wiring film. Therefore, highly reliable semiconductor devices and the fabrication method thereof may be provided.

## Claims

1. A method of making a semiconductor device comprising: providing a semiconductor substrate (1) of one conductivity type and having a top surface,
forming at least one doped region (6) having a dopant impurity of the other conductivity type in the semiconductor substrate of one conductivity type and opening onto the top surface thereof,
forming an insulation layer (3) on the top surface of the semiconductor substrate of one conductivity type, to include a relatively thick insulation region (2) and an adjoining relatively thin insulation region (3),
forming a wiring layer (5a) of electrically conductive material over the insulation layer,
patterning the wiring layer of electrically conductive material, to expose a portion of the relatively thin insulation region (3) of the insulation layer therebeneath,
forming an interlevel insulating layer (8) over the patterned wiring layer (5a) and the previously-formed insulation layer (3),
forming a contact hole (9) through said interlevel insulating layer (8), said patterned wiring layer (5a), and said insulation layer (3) and
forming an electrically conductive contact member (11) of material having a dopant impurity of said other conductivity type in the contact hole in engagement with said patterned wiring layer such that the electrically conductive contact member (11) fills the contact hole and extends through said interlevel insulating layer (8) and the relatively thin insulation region of said insulation layer into engagement with the top surface of said semiconductor substrate of one conductivity type and said one doped region of the other conductivity type,
characterized in that
the formation of at least one doped region (6) of the other conductivity type in the semiconductor substrate of one conductivity type occurs after the formation of the insulation layer on the top surface of the semiconductor substrate of said one conductivity type and the formation and patterning of the layer of electrically conductive material over the insulation layer, and is accomplished through the portion of the relatively thin insulation region of the insulation layer exposed by the patterning of the layer of electrically conductive material in defining the wiring layer of electrically conductive material, so that the patterned wiring layer of electrically conductive material is aligned with respect to said at least one doped region having a dopant impurity of said other conductivity type,
the contact hole is formed by removing a portion of said patterned wiring layer (5a) and a corresponding portion of the relatively thin insulation region (3) of said insulation layer therebeneath to expose the top surface of the semiconductor substrate of one conductivity type and of said one doped region located in a position partially exposing said one doped region of the other conductivity type which opens onto the top surface of the semiconductor substrate of one conductivity type while also exposing a portion of the top surface of the semiconductor substrate of one conductivity type and
dopant impurity of the other conductivity type is diffused from said electrically conductive contact member as formed in the contact hole into said semiconductor substrate of one conductivity type to define a diffused doped region (10) of the other conductivity type spanning the contact hole and extending across said semiconductor substrate of said one conductivity type to merge with said one doped region of the other conductivity type to at least augment the electrical connection between the contact member and said one doped region of the other conductivity type.

2. A method of making a semiconductor device as set forth in Claim 1, further characterized in that the formation of said at least one doped region (6) of the other conductivity type is accomplished by selective ion implantation of the dopant impurity of the other conductivity type into the semiconductor substrate of said one conductivity type.

3. A method of making a semiconductor device as set forth in either of Claims 1-2, further characterized in that the wiring layer is formed over the insulation layer by depositing a layer of polycrystalline semiconductor material over the insulation layer,
providing the layer of polycrystalline semiconductor material with a dopant impurity of the other conductivity type, and
defining the wiring layer of electrically conductive material by patterning the layer of polycrystalline semiconductor material.

4. A method of making a semiconductor device as set forth in Claim 3, further characterized in that the contact member is formed in the contact hole by depositing a second layer of polycrystalline semiconductor material over the insulation layer and filling the contact hole extending therethrough,
providing the second layer of polycrystalline semiconductor material with a dopant impurity of the other conductivity type, and
defining the contact member of electrically conductive material by removing all of the second layer of polycrystalline semiconductor material except for the portion thereof within the contact hole.

5. A method of making a semiconductor device as set forth in Claim 4, further characterized by
subjecting the second layer of polycrystalline semiconductor material to heat annealing to lower the electrical resistance thereof sufficiently to make the material electrically conductive, and
thereafter defining the contact member of electrically conductive material by removing all of the annealed second layer of polycrystalline semiconductor material except for the portion thereof within the contact hole.

6. A method of making a semiconductor device as set forth in Claim 5, further characterized in that the diffusion of the dopant impurity of the other conductivity type from the electrically conductive contact member into said semiconductor substrate of one conductivity type occurs in response to the heat annealing of the second layer of polycrystalline semiconductor material.

7. A method of making a semiconductor device as set forth in any of Claims 1-6, further characterized in that
in the step of patterning the wiring layer of electrically conductive material, a gate electrode (5b), disposed on the relatively thin insulation region (3) of the insulation layer and positioned over a portion of the semiconductor substrate (1) of said one conductivity type, is formed,
in said step of forming at least one doped region, a pair of spaced apart doped regions (6,7) having a dopant impurity of the other conductivity type are formed in the semiconductor substrate of said one conductivity type, open onto the top surface thereof and aligned with said gate electrode,
said pair of doped regions of the other conductivity type being respectively a source region and a drain region,
said electrically conductive contact member of material having a dopant impurity of said other conductivity type is formed in the contact hole in engagement with said patterned wiring layer and one of the source and drain regions of the other conductivity type spaced from said gate electrode, and
said dopant impurity of the other conductivity type is diffused from said electrically conductive contact member into said semiconductor substrate of one conductivity type, thereby defining the diffused doped region of the other conductivity type spanning the contact hole and extending across said semiconductor substrate of said one conductivity type to merge with said one of the source and drain regions of the other conductivity type to at least augment the electrical connection between the contact member and said one of said source and drain regions of the other conductivity type.

## Patentansprüche

1. Verfahren zum Herstellen eines Halbleiterbauelements, umfassend:
es wird ein einen Leitfähigkeitstyp aufweisendes Halbleitersubstrat (1), das eine obere Fläche besitzt, vorgesehen,
es wird wenigstens ein mit einem Dotierstoff des anderen Leitfähigkeitstyps dotierter Bereich (6) in dem den einen Leitfähigkeitstyp aufweisenden Halbleitersubstrat gebildet, der zu der oberen Fläche des Substrats hinläuft,
es wird eine Isolationsschicht (3) auf der oberen Fläche des den einen Leitfähigkeitstyp aufweisenden Halbleitersubstrats so gebildet, daß sie einen relativ dicken Isolationsbereich (2) und einen daran angrenzenden relativ dünnen Isolationsbereich (3) umfaßt,
es wird eine aus einem elektrisch leitfähigen Material bestehende Leitungsschicht (5a) über der Isolationsschicht gebildet,
die aus elektrisch leitfähigem Material bestehende Leitungsschicht wird strukturiert, um einen Teil des relativ dünnen Isolationsbereichs (3) der darunterliegenden Isolationsschicht freizulegen,
es wird eine schichtenübergreifende Isolationsschicht (8) über der strukturierten Leitungsschicht (5a) und der vorher gebildeten Isolationsschicht (3) gebildet,
es wird ein Kontaktloch (9) hergestellt, das durch die schichtenübergreifende Isolationsschicht (8), die strukturierte Leitungsschicht (5a) und die Isolationsschicht (3) hindurchläuft und
es wird in dem Kontaktloch ein elektrisch leitfähiges Kontaktelement (11) hergestellt, das aus einem Material besteht, das mit einem den anderen Leitfähigkeitstyp aufweisenden Dotierstoff dotiert ist, und das so an der strukturierten Leitungsschicht angreift, daß das elektrisch leitfähige Kontaktelement (11) das Kontaktloch ausfüllt und sich durch die schichtenübergreifende Isolationsschicht (8) und den relativ dünnen Isolationsbereich der Isolationsschicht hindurch erstreckt, bis es an der oberen Fläche des den einen Leitfähigkeitstyp aufweisenden Halbleitersubstrats und dem einen, den anderen Leitfähigkeitstyp aufweisenden dotierten Bereich angreift;
dadurch gekennzeichnet, daß
die Bildung des wenigstens einen, den anderen Leitfähigkeitstyp aufweisenden dotierten Bereiches (6) in dem den einen Leitfähigkeitstyp aufweisenden Halbleitersubstrat nach der Bildung der Isolationsschicht auf der oberen Fläche des den einen Leitfähigkeitstyp aufweisenden Halbleitersubstrats und der Bildung und dem Strukturieren der aus elektrisch leitfähigem Material bestehenden Schicht über der Isolationsschicht erfolgt, und durch den Teil des relativ dünnen Isolationsbereiches der Isolationsschicht hindurch erfolgt, der beim Definieren der aus elektrisch leitfähigem Material bestehenden Schicht durch das Strukturieren der aus elektrisch leitfähigem Material bestehenden Schicht freigelegt wurde, so daß die strukturierte, aus elektrisch leitfähigem Material bestehende Leitungsschicht mit dem wenigstens einen, den anderen Leitfähigkeitstyp aufweisenden dotierten Bereich in Ausrichtung gebracht wird,
das Kontakt loch durch Entfernen eines Teils der strukturierten Leitungsschicht (5a) und eines entsprechenden Teils des relativ dünnen Isolationsbereichs (3) der darunterliegenden Isolationsschicht gebildet wird, um die obere Fläche des den einen Leitfähigkeitstyp aufweisenden Halbleitersubstrats und des einen dotierten Bereichs freizulegen, wobei das Kontaktloch so liegt, daß der eine, den anderen Leitfähigkeitstyp aufweisende dotierte Bereich, der zu der oberen Fläche des den einen Leitfähigkeitstyp aufweisenden Substrats führt, teilweise freigelegt wird, während außerdem ein Teil der oberen Fläche des den einen Leitfähigkeitstyp aufweisenden Halbleitersubstrats freigelegt wird, und
den anderen Leitfähigkeitstyp aufweisender Dotierstoff von dem in dem Kontaktloch gebildeten, elektrisch leitfähigen Kontaktelement in das den einen Leitfähigkeitstyp aufweisende Halbleitersubstrat diffundiert, so daß ein den anderen Leitfähigkeitstyp aufweisender dotierter Bereich (10) gebildet wird, der sich über das Kontaktloch spannt und sich über das den einen Leitfähigkeitstyp aufweisende Halbleitersubstrat erstreckt, um in den den anderen Leitfähigkeitstyp aufweisenden dotierten Bereich einzumünden, so daß die elektrische Verbindung zwischen dem Kontaktelement und dem den anderen Leitfähigkeitstyp aufweisenden dotierten Bereich zumindest verbessert wird.

2. Verfahren zum Herstellen eines Halbleiterbauelements nach Anspruch 1, darüber hinaus dadurch gekennzeichnet, daß die Bildung des wenigstens einen, den anderen Leitfähigkeitstyp aufweisenden dotierten Bereichs (6) durch selektive Ionenimplantation des den anderen Leitfähigkeitstyp aufweisenden Dotierstoffs in das den einen Leitfähigkeitstyp aufweisende Halbleitersubstrat erzielt wird.

3. Verfahren zum Herstellen eines Halbleiterbauelements nach einem der Ansprüche 1 bis 2 , darüber hinaus dadurch gekennzeichnet, daß
die Leitungsschicht über der Isolationsschicht gebildet wird, indem eine Schicht aus polykristallinem Halbleitermaterial über der Isolationsschicht abgeschieden wird,
die Schicht aus polykristallinem Halbleitermaterial mit einem den anderen Leitfähigkeitstyp aufweisenden Dotierstoff versehen wird, und
die aus elektrisch leitfähigem Material bestehende Leitungsschicht definiert wird, indem die Schicht aus polykristallinem Halbleitermaterial strukturiert wird.

4. Verfahren zum Herstellen eines Halbleiterbauelements nach Anspruch 3, darüber hinaus dadurch gekennzeichnet, daß
das Kontaktelement in dem Kontaktloch durch Abscheiden einer zweiten Schicht aus polykristallinem Halbleitermaterial über der Isolationsschicht gebildet wird und das es das sich dadurch erstreckende Kontaktloch ausfüllt,
die zweite Schicht aus polykristallinem Halbleitermaterial mit einem den anderen Leitfähigkeitstyp aufweisenden Dotierstoff versehen wird und
das aus elektrisch leitfähigem Material bestehende Kontaktelement definiert wird, indem die gesamte zweite, aus polykristallinem Halbleitermaterial bestehende Schicht, mit Ausnahme des Teils innerhalb des Kontaktlochs, entfernt wird.

5. Verfahren zum Herstellen eines Halbleiterbauelements nach Anspruch 4, darüber hinaus dadurch gekennzeichnet, daß
die zweite Schicht aus polykristallinem Halbleitermaterial einem Ausheizprozeß ausgesetzt wird, um ihren elektrischen Widerstand so weit zu vermindern, daß das Material elektrisch leitfähig wird, und
danach das aus elektrisch leitfähigem Material bestehende Kontaktelement definiert wird, indem die gesamte ausgeheizte zweite, aus polykristallinem Halbleitermaterial bestehende Schicht, mit Ausnahme des Teils innerhalb des Kontaktlochs, entfernt wird.

6. Verfahren zum Herstellen eines Halbleiterbauelements nach Anspruch 5, darüber hinaus dadurch gekennzeichnet, daß die Diffusion des den anderen Leitfähigkeitstyp aufweisenden Dotierstoffs von dem elektrisch leitfähigen Kontaktelement in das den einen Leitfähigkeitstyp aufweisende Halbleitersubstrat als Reaktion auf den Ausheizprozeß der zweiten Schicht aus polykristallinem Halbleitermaterial auftritt.

7. Verfahren zum Herstellen eines Halbleiterbauelements nach einem der Ansprüche 1 bis 6, darüber hinaus dadurch gekennzeichnet, daß
während des Schritts des Strukturierens der aus elektrisch leitfähigem Material bestehenden Leitungsschicht eine Gateelektrode (5b) gebildet wird, die auf dem relativ dünnen Isolationsbereich (3) der Isolationsschicht angeordnet ist und über einem Teil des den einen Leitfähigkeitstyp aufweisenden Halbleitersubstrats (1) liegt ist,
während des Schritts des Bildens wenigstens eines dotierten Bereichs ein Paar von beabstandeten, den anderen Leitfähigkeitstyp aufweisenden dotierten Bereichen (6, 7) in dem den einen Leitfähigkeitstyp aufweisenden Substrat gebildet wird, die in Ausrichtung mit der Gateelektrode zu der oberen Fläche des Halbleitersubstrats hinlaufen, wobei das Paar der den anderen Leitfähigkeitstyp aufweisenden dotierten Bereiche jeweils aus einem Sourcebereich und einem Drainbereich besteht,
das elektrisch leitfähige Kontaktelement, dessen Material mit einem den anderen Leitfähigkeitstyp aufweisenden Dotierstoff dotiert ist, in dem Kontaktloch so hergestellt wird, daß es an der strukturierten Leitungsschicht und an einem der den anderen Leitfähigkeitstyp aufweisenden Bereiche des aus dem Source- und dem Drainbereich gebildeten Paares angreift und in Abstand zu der Gateelektrode angeordnet ist, und
der den anderen Leitfähigkeitstyp aufweisende Dotierstoff von dem elektrisch leitfähigen Element in das den einen Leitfähigkeitstyp aufweisende Halbleitersubstrat diffundiert, wodurch der diffundierte, den anderen Leitfähigkeitstyp aufweisende dotierte Bereich definiert wird, der sich über das Kontakt loch spannt und sich über das den einen Leitfähigkeitstyp aufweisende Halbleitersubstrat erstreckt, um in den einen der den anderen Leitfähigkeitstyp aufweisenden Bereiche des aus dem Source- und dem Drainbereich gebildeten Paares einzumünden, so daß die elektrische Verbindung zwischen dem Kontaktelement und dem einen den anderen Leitfähigkeitstyp aufweisenden Bereich des aus dem Source- und dem Drainbereich gebildeten Paares zumindest verbessert wird.

## Revendications

1. Procédé pour fabriquer un dispositif à semiconducteurs consistant à :
prévoir un substrat semiconducteur (1) possédant un premier type de conductivité et possédant une surface supérieure,
former au moins une première région dopée (6) contenant une impureté dopante possédant l'autre type de conductivité dans le substrat semiconducteur possédant le premier type de conductivité et débouchant dans la surface supérieure du substrat,
former une couche isolante (3) sur la surface supérieure du substrat semiconducteur possédant le premier type de conductivité pour inclure une région isolante relativement épaisse (2) et une région isolante adjacente relativement mince (3),
former une couche de câblage (5a) formée d'un matériau électriquement conducteur sur la couche isolante,
structurer la couche de câblage formée du matériau électriquement conducteur pour exposer une partie de la région isolante relativement mince (3) de la couche isolante située au-dessous,
former une couche isolante inter-niveaux (8) au-dessus de la couche de câblage structurée (5a) et de la couche isolante (3) formée précédemment,
former un trou de contact (9) à travers ladite couche isolante inter-niveaux (8), ladite couche de câblage structurée (5a) et ladite couche isolante (3), et
former un élément de contact électriquement conducteur (11) formé d'un matériau possédant une impureté dopante possédant ledit autre type de conductivité dans le trou de contact, en contact avec ladite couche de câblage structurée de telle sorte que l'élément de contact électriquement conducteur (11) remplit le trou de contact et s'étend à travers ladite couche isolante inter-niveaux (8) et la couche isolante relativement mince de ladite couche isolante pour venir en contact avec la surface supérieure dudit substrat conducteur possédant le premier type de conductivité et avec ladite première région dopée possédant l'autre type de conductivité;
caractérisé en ce que la formation de la au moins une première région dopée (6) possédant l'autre type de conductivité dans le substrat semiconducteur possédant le premier type de conductivité s'effectue après la formation de la couche isolante sur la surface supérieure du substrat semiconducteur possédant ledit premier type de conductivité et après la formation et la structuration de la couche d'un matériau électriquement conducteur au-dessus de la couche isolante, et est exécutée dans la partie de la région isolante relativement mince de la couche isolante exposée lors de la structuration de la couche du matériau électriquement conducteur lors de la définition de la couche de câblage formée du matériau électriquement conducteur, de sorte que la couche de câblage structurée formée du matériau électriquement conducteur est alignée par rapport à ladite au moins une première région dopée possédant une impureté dopante ayant ledit autre type de conductivité;
le trou de contact est formé par élimination d'une partie de ladite couche de câblage structurée (5a) et d'une partie correspondante de la couche isolante relativement mince (3) de ladite couche isolante située au-dessous pour exposer la surface supérieure du substrat semiconducteur possédant un premier type de conductivité et de ladite une première région dopée située dans une position qui expose partiellement ladite première région dopée possédant l'autre type de conductivité, qui débouche dans la surface supérieure du substrat semiconducteur possédant le premier type de conductivité, tout en exposant également une partie de la surface supérieure du substrat semiconducteur possédant le premier type de conductivité, et
on fait diffuser une impureté dopante possédant l'autre type de conductivité à partir dudit élément de contact électriquement conducteur tel qu'il est formé dans le trou de contact situé dans ledit substrat semiconducteur possédant le premier type de conductivité pour définir une région dopée diffusée (10) possédant l'autre type de conductivité, qui franchit le trou de contact et s'étend en travers dudit substrat semiconducteur possédant ledit premier type de conductivité pour rejoindre ladite première région dopée possédant l'autre type de conductivité de manière à au moins augmenter la connexion électrique entre l'élément de contact et ladite première région dopée possédant l'autre type de conductivité.

2. Procédé pour fabriquer un dispositif à semiconducteurs selon la revendication 1, caractérisé en outre en ce que la formation de ladite au moins une première région dopée (6) possédant l'autre type de conductivité est réalisée au moyen d'une implantation ionique sélective de l'impureté dopante possédant l'autre type de conductivité dans le substrat semiconducteur possédant ledit premier type de conductivité.

3. Procédé pour fabriquer un dispositif à semiconducteurs l'une ou l'autre des revendications 1-2, caractérisé en ce que la couche de câblage est formée sur la couche isolante par dépôt d'une couche d'un matériau semiconducteur polycristallin sur la couche isolante,
qu'on applique à la couche de matériau semiconducteur polycristallin une impureté dopante possédant l'autre type de conductivité, et
qu'on définit la couche de câblage formée d'un matériau électriquement conducteur par structuration de la couche de matériau semiconducteur polycristallin.

4. Procédé pour fabriquer un dispositif à semiconducteurs selon la revendication 3, caractérisé en outre en ce qu'on forme l'élément de contact dans le trou de contact par dépôt d'une seconde couche de matériau semiconducteur polycristallin sur la couche isolante et remplissage du trou de contact qui s'étend en travers de cette couche,
qu'on introduit une impureté dopante possédant l'autre type de conductivité dans la seconde couche de matériau semiconducteur polycristallin, et
qu'on définit l'élément de contact formé du matériau électriquement conducteur en supprimant la totalité de la seconde couche de matériau semiconducteur polycristallin, hormis sa partie située dans le trou de contact.

5. Procédé pour fabriquer un dispositif à semiconducteurs selon la revendication 4, caractérisé en outre en ce
qu'on soumet la seconde couche de matériau semiconducteur polycristallin à un recuit pour réduire sa résistance électrique de manière suffisante pour rendre ce matériau électriquement conducteur, et
qu'ensuite on définit l'élément de contact formé du matériau électriquement conducteur en éliminant la totalité de la seconde couche recuite du matériau semiconducteur polycristallin, hormis sa partie située dans le trou de contact.

6. Procédé pour fabriquer un dispositif à semiconducteurs selon la revendication 5, caractérisé en outre en ce que la diffusion de l'impureté dopante possédant l'autre type de conductivité depuis l'élément de contact électriquement conducteur dans ledit substrat semiconducteur possédant le premier type de conductivité s'effectue en réponse au recuit de la seconde couche du matériau semiconducteur polycristallin.

7. Procédé pour fabriquer un dispositif à semiconducteurs selon l'une quelconque des revendications 1-6, caractérisé en outre en ce que lors de ladite étape de formation d'au moins une région dopée, lors de l'étape de structuration de la couche de câblage formée du matériau électriquement conducteur, on forme une électrode de grille (5b), disposée sur la région isolante relativement mince (3) de la couche isolante et on la positionne au-dessus d'une partie du substrat semiconducteur (1) possédant ledit premier type de conductivité, et on forme un couple de régions espacées dopées (6,7) comportant une impureté dopante possédant l'autre type de conductivité dans le substrat semiconducteur possédant ledit premier type de conductivité, qui débouchent dans la surface supérieure du substrat et sont alignées avec ladite électrode de grille, ledit couple de régions dopées possédant l'autre type de conductivité étant respectivement une région de source et une région de drain.
